# EUROPÄISCHE PATENTSCHRIFT

(11) **EP 0 728 391 B1**
(45) Veröffentlichungstag und Bekanntmachung des Hinweises auf die Patenterteilung: **29.07.1998**
(21) Anmeldenummer: 94926093.9
(22) Anmeldetag: 08.09.1994
(51) Int. Cl.: H04L 7/027, H03F 3/45, H03F 3/193

(54) **VORRICHTUNG ZUR TAKTRÜCKGEWINNUNG**
CLOCK-RECOVERY CIRCUIT
CIRCUIT D'EXTRACTION DE SIGNAL D'HORLOGE

(30) Priorität: 13.11.1993 DE 4338873
(43) Veröffentlichungstag der Anmeldung: 28.08.1996
(73) Patentinhaber: FRAUNHOFER-GESELLSCHAFT ZUR FÖRDERUNG DER ANGEWANDTEN FORSCHUNG E.V., 80636 München (DE)
(72) Erfinder: WANG, Zhigong, D-79224 Umkirch (DE); BERROTH, Manfred, D-79395 Neuenburg (DE)
(74) Vertreter: RACKETTE Partnerschaft Patentanwälte
(86) Internationale Anmeldenummer: DE9401044
(87) Internationale Veröffentlichungsnummer: WO9514339

(56) Entgegenhaltungen:
- EP-A- 0 228 941
- US-A- 5 089 789
- ANNALES DES TELECOMMUNICATIONS, Bd.48, Nr.3-4, April 1993, FR Seiten 132 - 147 WANG 'MultiGbit/s data regeneration and clock recovery IC design' in der Anmeldung erwähnt
- ELECTRONICS LETTERS., Bd.23, Nr.9, 23. April 1987, STEVENAGE GB Seiten 454 - 456 WANG ET AL. 'New proposal for a multigigabit/s clock recovery IC based on a standard silicon bipolar technology'
- PATENT ABSTRACTS OF JAPAN vol. 7, no. 72 (E-166) 25. März 1983 & JP,A,58 003 307 (TOUYOU TSUUSHINKI KK)
- PATENT ABSTRACTS OF JAPAN vol. 12, no. 489 (E-696) 21. Dezember 1988 & JP,A,63 204 851 (FUJITSU)
- PATENT ABSTRACTS OF JAPAN vol. 13, no. 26 (E-706) 20. Januar 1989 & JP,A,63 228 816 (FUJITSU)
- Dissertation Z. Wang, "Monolithisch-integrierte Silizium-bipolar-Schaltungen zur Taktrückgewinnung bei Datenraten von mehreren Gbit/s", Schriftenreihe des Instituts für Elektronik, Universität Bochum, Heft Nr. 902/1, Bochum 1990

## Beschreibung

Die Erfindung betrifft eine Vorrichtung zur Taktrückgewinnung aus einem insbesondere aus einem digitalen Datensignal gebildeten wechselspannungsbehafteten Eingangssignal mit einem Frequenzmischer, dem an einem ersten Eingang ein der Taktfrequenz des wechselspannungsbehafteten Eingangssignales zugeordnetes Signal einspeisbar ist, mit einem Filter und einem Verstärker, mit denen ein schmalbandiger Frequenzbereich des Ausgangssignales des Frequenzmischers verstärkbar ist, wobei die aus dem Filter und dem Verstärker gebildete Filter- und Verstärkereinheit eine hohe Gesamtgüte aufweist, und mit einer Rückkoppelleitung, mit der das Ausgangssignal des Verstärkers einem zweiten Eingang des Frequenzmischers zuführbar ist.

Eine derartige Vorrichtung ist aus dem Artikel "MultiGbits/s data regeneration and clock recovery IC design" von Zhigong Wang in der Zeitschrift *Annales des Télécommunikations,* Band 48, Nr. 3-4, erschienen im Jahr 1993, Seiten 132 bis 147 bekannt. Bei dieser Vorrichtung ist ein Flankendetektor mit einer monolithisch integrierten Exklusiv-Oder-Schaltung vorgesehen, mit der Flanken des wechselspannungsbehafteten Eingangssignales über einen Exklusiv-Oder-Vergleich von zwei zueinander phasenverschobenen, aus dem wechselspannungsbehafteten Eingangssignal gebildeten Signalanteilen detektierbar sind. Die Filter- und Verstärkerfunktion ist mit einem externen Filter mit einer Güte von etwa 600 und einem monolithisch integrierten Verstärker getrennt durchführbar, wobei das Filter vorzugsweise als ein akustisches Oberflächenwellenfilter ausgeführt ist.

Die Vorrichtung weist eine Begrenzerschaltung zum Einstellen des Pegels des Ausgangstaktsignales auf einen Maximalwert auf, die dem Verstärker nachgeschaltet ist. Das Ausgangssignal der Begrenzerschaltung ist dem zweiten Eingang des Frequenzmischers mit der Rückkoppelleitung zugeführt. Mit dieser Vorrichtung ist ein Taktsignal aus Datensignalen mit einer Datenrate von etwa 3 Gigabit pro Sekunde regenerierbar. In einer modifizierten Ausführung dieser Vorrichtung sind dem Filter zur Erhöhung der höchsten einspeisbaren Datenüber-tragungsrate auf 4,5 Gigabit pro Sekunde drei Verstärker nachgeschaltet.

In einer weiteren Ausführungsform der oben genannten Vorrichtung zur Taktrückgewinnung ist das Oberflächenwellenfilter durch ein dielektrisches Resonatorfilter ersetzt. Das dielektrische Resonatorfilter ist bei einer höheren Taktfrequenz von etwa 10 Gigahertz einsetzbar, so daß die Arbeitsfrequenz gegenüber einer Vorrichtung mit einem Oberflächenwellenfilter erhöhbar ist.

Obwohl die vorgenannten Vorrichtungen zur Taktrückgewinnung den Vorteil aufweisen, daß die höchste einspeisbare Datenrate durch Abstimmen der Mittenfrequenz des Filters auf die Hälfte der Taktfrequenz des Datensignales verdoppelbar ist, ergeben sich durch die Ausführung des Filters als ein externes Bauelement hoher Güte drei Probleme bei Datenraten von mehr als 10 Gigabit pro Sekunde.

Das erste Problem ist, daß Oberflächenwellen- und dielektrische Resonatorfilter für eine Taktfrequenz von mehr als 5 Gigahertz und mit einer Güte von mehreren Hundert gemäß des derzeitigen Standes der Technik nur mit einem sehr hohen Fertigungsaufwand hergestellt werden können.

Das zweite Problem besteht darin, daß der unsymmetrische Aufbau und die niederohmigen Ein- und Ausgänge beider Filterarten es verhindern, einen stabilen Gesamtschaltkreis bei einer sehr hohen Arbeitsfrequenz zu realisieren. Das dritte Problem ist, daß der hybride Aufbau des Gesamtschaltkreises für ein Massenprodukt einen sehr hohen Fertigungsaufwand mit entsprechend hohen Stückkosten nach sich zieht.

Aus der Druckschrift "New Proposal for a MultiGigabit/s Clock Recovery IC Based on a Standard Silicon Bipolar Technology" von Z. Wang und U. Langmann in Electronics Letters 23 (1987) Nr. 9, Seiten 454, 455 ist eine Vorrichtung zur Taktrückgewinnung bekannt, bei der in einem Rückkoppelkreis zwischen zwei monolithisch integriert aufgebauten Bandpaßverstärkern ein externes Oberflächenwellenfilter vorgesehen ist. Die extrahierte Frequenz entspricht der Hälfte der Taktfrequenz des einem Frequenzmischer eingespeisten Eingangssignal. Die Gesamtgüte einer durch die beiden Bandpaßverstärker und das zwischengeschaltete externe Filter gebildeten Filter- und Verstärkereinheit ist im wesentlichen durch die verhältnismäßig hohe Güte des Oberflächenwellenfilters bestimmt, da die Bandpaßverstärker jeweils eine für Filterzwecke völlig unzureichende Güte mit einem Wert von typischerweise zwei aufweisen.

Aus der von Z. Wang im Jahr 1990 vorgelegten Dissertation mit dem Titel "Monolithisch-integrierte Silizium-Bipolar-Schaltungen zur Taktrückgewinnung bei Datenraten von mehreren GBit/S" zur Erlangung des Grades eines Doktor-Ingenieurs der Fakultät für Elektrotechnik an der Ruhr-Universität Bochum ist bekannt, daß eine Filter-und Verstärkereinheit mit einem einzigen externen Filter in einem Rückkoppelkreis ähnlich wie bei der vorgenannten Druckschrift im Vergleich zu der Güte des einzelnen Filters eine um einen Faktor vier höhere Gesamtgüte aufweist. Allerdings ist auch bei dieser Vorrichtung zur Taktrückgewinnung die Güte des einzelnen externen Filters mit einem Wert von etwa 200 zum Erreichen einer Gesamtgüte von 800 aus fertigungstechnischen Gründen noch immer nachteilig hoch.

Der Erfindung liegt die Aufgabe zugrunde, eine Vorrichtung der eingangs genannten Art zu schaffen, die auch bei hohen und höchsten Taktfrequenzen des wechselspannungsbehafteten Eingangssignales eine technologisch verhältnismäßige einfach herzustellende Filter- und Verstärkereinheit aufweist, wobei die Filter- und Verstärkereinheit in einfacher Weise an unterschiedliche Anforderungen an die Gesamtgüte anpaßbar ist.

Diese Aufgabe wird erfindungsgemäß dadurch gelöst, daß wenigstens zwei in Reihe geschaltete, die Filter- und Verstärkereinheit bildende Resonanzverstärker vorgesehen sind, die Schwingkreise mit in monolithisch integrierter Bauweise ausgeführten Induktivitäten aufweisen, wobei die Resonanzverstärker eine im Vergleich zu der Gesamtgüte der Filter- und Verstärkereinheit niedrige Güte aufweisen, so daß mit der aus den kaskadierten Resonanzverstärkern gebildeten Filter- und Verstärkereinheit hoher Gesamtgüte ein schmalbandiger Frequenzbereich des Ausgangssignales des Frequenzmischers verstärkbar ist.

Erfindungsgemäß ist die Filter- und Verstärkereinheit mit hoher Gesamtgüte aus mehreren in Reihe geschalteten Resonanzverstärkern gebildet, wobei jeder Resonanzverstärker Schwingkreis mit monolithisch integriert aufgebauten Induktivitäten aufweist. Diese monolithisch integriert ausgeführten Induktivitäten führen zu einer im Vergleich zu der Gesamtgüte der Filter- und Verstärkereinheit beispielsweise zu einer um eine Größenordnung niedrigeren Güte eines einzelnen Resonanzverstärkers. Durch das erfindungsgemäße Kaskadieren der Resonanzverstärker in einem Rückkoppelkreis ergibt sich eine im wesentliche lineare Zunahme der Gesamtgüte der Filter- und Verstärkereinheit mit der Anzahl der Resonanzverstärker, bei der in Abhängigkeit der Phasenverschiebung des auf den Frequenzmischer rückgeführten Ausgangssignales des letzten Resonanzverstärkers in Bezug auf das zu untersuchende Eingangsignal bereits mit wenigen, fertigungstechnisch problemlos integriert herstellbaren Resonanzverstärkern eine hohe Gesamtgüte erreichbar ist. Die Gesamtgüte hängt ebenfalls von der Güte und der Anzahl der einzelnen Resonanzverstärker ab. so daß eine einfache Einstellung der Gesamtgüte erzielt ist.

In einer vorteilhaften Weiterbildung ist durch das Vorsehen einer Schutzschaltung zur Lasttrennung eine störungsarme Kaskadierung der Resonanzverstärker erzielt.

In einer weiteren zweckmäßigen Ausgestaltung der Erfindung weist ein Resonanzverstärker jeweils einen Differenzverstärker mit zwei Feldeffekttransistoren auf, deren Drainanschlüsse jeweils über eine Spule als Induktivität und wenigsten eine Diode an eine Schaltmasse angeschlossen sind, deren Gateanschlüsse an Eingangsanschlüsse des Resonanzverstärkers angeschlossen sind und deren Sourceanschlüsse über eine Konstantstromquelle an einer negativen Versorgungsspannung liegen. Durch das Vorsehen von Differenzverstärkern mit Feldeffekttransistoren, deren Kapazitäten zusammen mit den Spulen einen Schwingkreis niedriger Güte bilden, ist ein balanciertes Ausgangssignal erreicht.

Durch die Ausgestaltung der Schutzschaltung mit Ausgangsfeldeffekttransistoren und Dioden sind zum einen Rückkopplungen unterdrückt. Zum anderen sind durch Beaufschlagen der Drainanschlüsse der Ausgangsfeldeffekttransistoren mit einer Abstimmspannung die in dem Schwingkreis wirkenden Kapazitäten veränderbar, so daß die Resonanzfrequenz und in Feinabstimmung die Phasenverschiebung einstellbar sind.

Durch das Vorsehen von Kompensationsfeldeffekttransistoren sowie des Kondensators ist die Güte des Ausgangsignales durch die gegenphasige Kopplung parasitärer Kapazitäten des Differenzverstärkers gesteigert.

Durch das Verschieben der Phase des Ausgangsignales des in Signallaufrichtung letzten Resonanzverstärkers gegenüber dem an den ersten Eingangsanschlüssen des Frequenzmischers anliegenden Signal ist ein verhältnismäßig großer Proportionalitätsfaktor bei der Steigerung der Gesamtgüte der Filter- und Verstärkereinheit mit der Anzahl der Resonanzverstärker sichergestellt.

Weitere Vorteile und Ausgestaltungen der Erfindung ergeben sich aus den Unteransprüchen und der nachfolgenden Beschreibung von Ausgestaltungen unter Bezug auf die Figuren der Zeichnung. Es zeigen:
- Fig. 1: ein Blockschaltbild einer Vorrichtung zur Taktrückgewinnung,
- Fig. 2: ein Schaltbild eines Flankendetektors,
- Fig. 3: ein Schaltbild eines Frequenzmischers und
- Fig. 4: ein Schaltbild eines als Resonanzverstärkers ausgeführten Filter- und Verstärkerelementes.

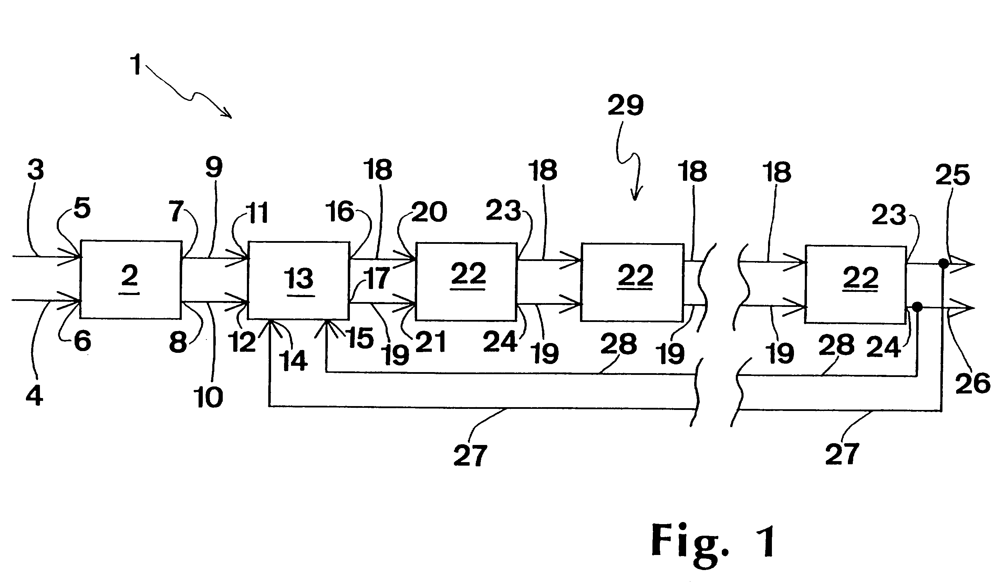

Fig. 1 zeigt in einem Blockschaltbild eine Vorrichtung 1 zur Taktrückgewinnung. Die Vorrichtung 1 zur Taktrückgewinnung weist einen Flankendetektor 2 auf, dem über zwei Datenleitungen 3, 4 und zwei Eingangsanschlüsse 5, 6 ein digitales Datensignal als ein wechselspannungsbehaftetes Eingangssignal einspeisbar ist. Das in den Datenleitungen 3, 4 laufende digitale Datensignal hat in diesem Ausführungsbeispiel ein sogenanntes Non-Return-to-Zero- (NRZ-) Format, bei dem der hohe Pegel einer logischen Eins innerhalb einer Taktperiode nicht auf den Pegel Null zurückgeht. Eine Abfolge von logischen Eins-Signalen ist somit als ein andauernder hoher Pegel über die entsprechende Zahl von Taktperioden dargestellt. Mit dem Flankendetektor 2 sind die Flanken des Datensignales detektierbar. Das der Taktfrequenz des Datensignales zugeordnete Ausgangssignal des Flankendetektors 2 ist über Ausgangsanschlüsse 7, 8, Leitungen 9, 10 und ersten Eingangsanschlüsse 11, 12 einem Frequenzmischer 13 zuführbar.

Das an den ersten Eingangsanschlüssen 11, 12 des Frequenzmischers 13 anliegende Signal ist mit einem an zweiten Eingangsanschlüssen 14, 15 des Frequenzmischers 13 anliegenden Taktsignal über eine Multiplikation der beiden Eingangssignale mischbar. Das an Ausgangsanschlüssen 16, 17 anliegende Ausgangssignal des Frequenzmischers 13 ist über Taktleitungen 18, 19 und über Eingangsanschlüsse 20, 21 einem Resonanzverstärker 22 einspeisbar. Mit dem Resonanzverstärker 22 ist das in den Taktleitungen 18, 19 anliegende Taktsignal in einem durch die Mittenfrequenz und Güte des Resonanzverstärker 22 vorbestimmten Frequenzbereich verstärkbar.

Das gegenüber dem an den Eingangsanschlüssen 20, 21 anliegenden Signal gefilterte und verstärkte Ausgangssignal des Resonanzverstärkers 22 ist an Ausgangsanschlüssen 23, 24 abgreifbar und über weitere Taktleitungen 18, 19 einem zweiten Resonanzverstärker 22 eingespeist, dessen Ausgangssignal weiteren Resonanzverstärkern 22 zugeführt ist, von denen in Fig. 1 lediglich der in Signallaufrichtung letzte Resonanzverstärker 22 dargestellt ist. An den Ausgangsanschlüssen 23, 24 des letzten Resonanzverstärkers 22 ist in Ausgangstaktleitungen 25, 26 das verstärkte und gefilterte, aus dem Datensignal regenerierte Ausgangstaktsignal geführt. Das Ausgangstaktsignal ist über an die Ausgangstaktleitungen 25, 26 angeschlossene Rückkoppelleitungen 27, 28 über die zweiten Eingangsanschlüsse 14, 15 dem Frequenzmischer 13 rückführbar. Die in Reihe geschalteten Resonanzverstärker 22 bilden eine Filter- und Verstärkereinheit 29.

Die Resonanzverstärker 22 sind, wie weiter unten näher erläutert, auf eine Mittenfrequenz abstimmbar. In einem Ausführungsbeispiel einer Vorrichtung 1 zur Taktrückgewinnung ist die Mittenfrequenz der Resonanzverstärker 22 auf die halbe Taktfrequenz des in den Datenleitungen 3, 4 anliegenden Datensignales mit einem NRZ-Format abgestimmt. Durch das multiplikative Mischen der Eingangssignale des Frequenzmischers 13 hat das Signal in den Taktleitungen 18, 19 eine Frequenz, die der Hälfte der Taktfrequenz des Datensignales entspricht. Durch das Halbieren der regenerierten Taktfrequenz sind somit Datensignale mit hohen Datenraten verarbeitbar.

Wenn beispielsweise zur Auswertung eines in einem Multiplexverfahren mit Überlagerung von Datensignalteilen mit unterschiedlichen Frequenzen erzeugten Datensignales die niedrigen Frequenzen des Taktsignales rückzugewinnen sind, weisen die Resonanzverstärker 22 den Bruchteil eines ganzzahligen Vielfachen des Faktors 2 der höchsten Taktfrequenz als Mittenfrequenz auf. Ist ein Ausgangstaktsignal mit der gleichen Frequenz wie die höchste Taktfrequenz des Datensignales erforderlich, sind die Resonanzverstärker 22 auf die Taktfrequenz des Datensignales abgestimmt. In diesem Fall ist der Flankendetektor 13 auf die zweite Harmonische der Takfrequenz des Datensignales abgestimmt. Dies ist insbesondere dann vorteilhaft, wenn die Bitrate des Datensignales verhältnismäßig niedrig ist.

Für ein Datensignal mit einem sogenannten Return-to-Zero- (RZ-) Format, bei dem der hohe Pegel einer logischen Eins innerhalb einer Taktperiode auf den unteren Wert zurückkehrt, ist die Vorrichtung 1 zur Taktrückgewinnung in zwei Betriebsarten betreibbar. In der ersten Betriebsart ist das Datensignal dem Frequenzmischer 13 direkt über die Eingangsanschlüsse 11, 12 eingespeist, wobei die Taktfrequenz des Datensignales der doppelten Arbeitsfrequenz der Resonanzverstärker 22 entspricht. In diesem Ausführungsbeispiel ist das der Taktfrequenz zugeordnete Signal das Datensignal selbst.

In der zweiten Betriebsart ist das Datensignal mit dem RZ-Format einem Flankendetektor 2 eingespeist, wobei die Taktfrequenz des Datensignales der Arbeitsfrequenz der Resonanzverstärker 22 entspricht. Der Flankendetektor 2 wirkt in dieser Betriebsart als ein Frequenzverdoppler, da er jeweils zwei Flanken pro Datenbit detektiert und an den Frequenzmischer 13 weiterleitet.

Durch das Kaskadieren von mehreren Resonanzverstärkern 22 in dem durch den Frequenzmischer 13, die aus den Resonanzverstärkern 22 gebildeten Filter- und Verstärkereinheit 29 und den Rückkoppelleitungen 27, 28 gebildeten Schaltkreis ergibt sich eine im wesentlichen lineare Zunahme der Gesamtgüte der Filter- und Verstärkereinheit 29 mit zunehmender Anzahl von Resonanzverstärkern 22, während bei einer Reihenschaltungen von Abstimmelementen ohne Rückkopplung die Erhöhung der Gesamtgüte von einem Abstimmelement zum nächsten kontinuierlich abnimmt, so daß zum Erreichen einer hohen Gesamtgüte der Reihenschaltung eine für praktische Anwendungen unzweckmäßig hohe Anzahl von Abstimmelementen erforderlich wäre.

Bei der in Fig. 1 dargestellten Filter- und Verstärkereinheit 29 sind die Resonanzverstärker 22, wie weiter unten näher erläutert, monolithisch integriert aufgebaut und weisen eine Güte von etwa 20 auf. Ist die Verzögerungszeit des Ausgangstaktsignales in den Ausgangstaktleitungen 25, 26 nur sehr wenig gegen das in den Leitungen 9, 10 anliegende Signal zeitverzögert, beträgt der Proportionalitätsfaktor der Zunahme der Gesamtgüte mit steigender Anzahl von Resonanzverstärkern 22 etwa 1,7. Dadurch ist bereits mit etwa zehn Resonanzverstärkern 22, die jeweils eine Güte von etwa 20 aufweisen, eine Gesamtgüte der Filter- und Verstärkereinheit 29 von etwa 340 erreicht, der für eine Vielzahl von Anwendungen der Vorrichtung 1 zur Taktrückgewinnung ausreichend ist.

Ist die Taktfrequenz des Datensignales so hoch, daß eine im Vergleich zur Taktperiode des Datensignales große Zeitverzögerung zwischen dem Eingangssignal eines Resonanzverstärkers 22 und dessen Ausgangssignal eintritt, nimmt der Proportionalitätsfaktor weiter zu. Er beträgt bei einer Zeitverzögerung, die einem Viertel der Taktperiode des Datensignales entspricht, etwa 3,0, bei einer Zeitverzögerung um die Hälfte der Taktperiode des Datensignales 4,2 und bei einer Zeitverzögerung um eine ganze Taktperiode etwa 6,8. Im letzten Fall ist bereits mit fünf Resonanzverstärkern 22 eine Gesamtgüte von 700 der Filter- und Verstärkereinheit 29 erreicht, die für die üblichen Anwendungen vollkommen ausreichend ist.

Im nachfolgenden Teil der Beschreibung ist für das Wort "Feldeffekttransistor" die übliche Abkürzung "FET" sowie die gebräuchlichen Begriffe "Gate", "Drain" und "Source" im Zusammenhang mit den Anschlüssen der Feldeffekttransistoren verwendet.

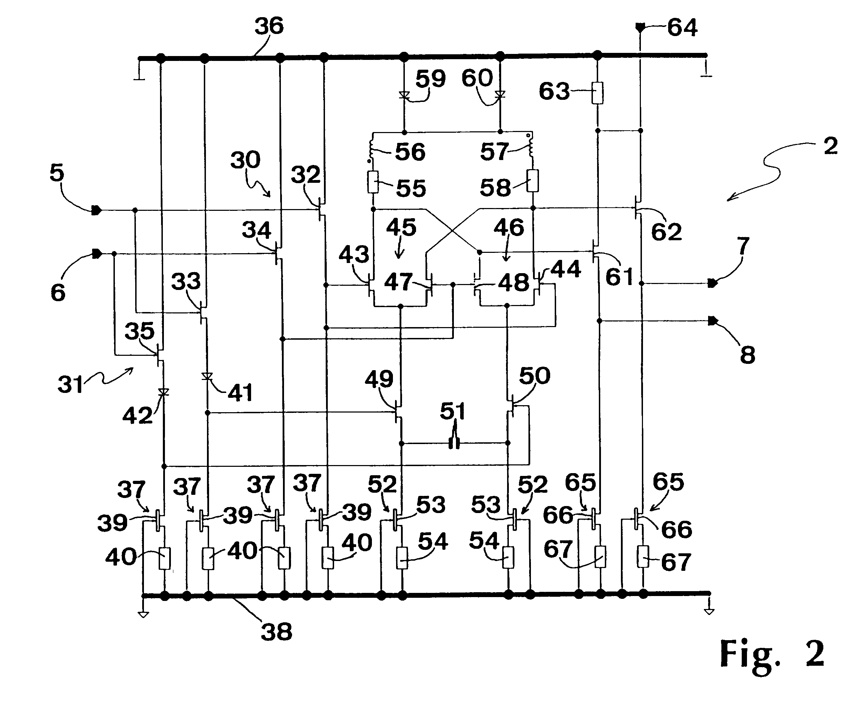

Fig. 2 zeigt in einem Schaltbild ein Ausführungsbeispiel eines monolithisch integriert aufgebauten Flankendetektors 2. Das an den Eingangsanschlüssen 5, 6 anliegende Datensignal ist einer ersten Eingangsstufe 30 und einer zweiten Eingangsstufe 31 zugeführt. Das an dem Eingangsanschluß 5 anliegende Signal ist dem Gateanschluß eines ersten Eingangs-FETs 32 der ersten Eingangsstufe 30 und einem ersten Eingangs-FET 33 der zweiten Eingangsstufe 31 eingespeist. Das an dem Eingangsanschluß 6 anliegende Signal ist einem zweiten Eingangs-FET 34 der ersten Eingangsstufe 30 und einem zweiten Eingangs-FET 35 der zweiten Eingangsstufe 31 zugeführt. Die Gateweiten der FETen 32, 33, 34, 35 betragen 10 Mikrometer und die Gatelängen 0,3 Mikrometer.

Die Drainanschlüsse der Eingangs-FETen 32, 33, 34, 35 sind mit einer Schaltmassenleitung 36 verbunden. Die Sourceanschlüsse der Eingangs-FETen 32, 34 liegen über Konstantstromquellen 37 an einer Versorgungsspannungsleitung 38. Die Sourceanschlüsse der Eingangs-FETen 33, 35 sind über jeweils eine Pegeldiode 41, 42 an jeweils eine Konstantstromquelle 37 angeschlossen. Die Versorgungsspannungsleitung 38 ist mit einer negativen Versorgungsspannung beaufschlagt.

Die Konstantstromquellen 37 weisen jeweils einen selbstleitenden FET 39 auf, dessen Drainanschluß schaltmassenseitig mit weiteren Bauelementen verbunden ist, dessen Gateanschluß an der Versorgungsspannungleitung 38 liegt, und dessen Sourceanschluß über einen Gegenkopplungswiderstand 40 zur Stromstabilisierung ebenfalls an der Versorgungsspannungsleitung 38 angeschlossen ist. In diesem Ausführungsbeispiel weisen die Gegenkopplungswiderstände 40 einen Wert von etwa 100 Ohm auf. Die Gateweiten der FETen 39 betragen 10 Mikrometer und die Gatelängen 0,3 Mikrometer.

An die sourceseitige Ausgangsleitung des ersten Eingangs-FETs 32 der ersten Eingangsstufe 30 sind die Gateanschlüsse von jeweils einem ersten Differenz-FET 43, 44 eines ersten Differenzverstärkers 45 und eines zweiten Differenzverstärkers 46 angeschlossen. Die Gateanschlüsse der zweiten Differenz-FETen 47, 48 des ersten Differenzverstärkers 45 und zweiten Differenzverstärkers 46 sind mit der sourceseitigen Ausgangsleitung des zweiten Eingangs-FETs 34 der ersten Eingangsstufe 30 verbunden.

Die Sourceanschlüsse des ersten Differenz-FETs 43 und des zweiten Differenz-FETs 47 des ersten Differenzverstärkers 45 sind zusammengeschaltet und an den Drainanschluß eines ersten Steuer-FETs 49 angeschlossen. Der Gateanschluß des ersten Steuer-FETs 49 ist zwischen die Pegeldiode 41 und den FET 39 der mit der Pegeldiode 41 verbundenen Konstantstromquelle 37 gelegt. Die Sourceanschlüsse des ersten Differenz-FETs 44 und zweiten Differenz-FETs 48 des zweiten Differenzverstärkers 46 sind ebenfalls zusammengeschaltet und an den Drainanschluß eines zweiten Steuer-FETs 50 angeschlossen. Der Gateanschluß des zweiten Steuer-FETs 50 ist zwischen die Pegeldiode 42 und den daran angeschlossenen Drainanschluß des FETs 39 der zugehörigen Konstantstromquelle 37 geschaltet.

Die Sourceanschlüsse des ersten Steuer-FETs 49 und des zweiten Steuer-FETs 50 sind über einen Koppelkondensator 51 gebrückt und jeweils über eine Konstantstromquelle 52 mit jeweils einem in gleicher Weise wie bei den Konstantstromquellen 37 geschalteten selbstleitenden FET 53 und einem Gegenkopplungswiderstand 54 an die Versorgungsspannungsleitung 38 gelegt. Die Gegenkopplungswiderstände 54 der Konstantstromquellen 52 haben einen Wert von etwa 200 Ohm. Die Gatelängen der selbstleitenden FETen 53 der Konstantstromquellen 52 haben einen Wert von 0,3 Mikrometer und die Gateweiten einen Wert von etwa 5 Mikrometer.

Der Drainanschluß des ersten Differenz-FETs 43 des ersten Differenzverstärkers 45 ist über einen ersten Schwingkreiswiderstand 55, eine erste Schwingkreisspule 56, eine zweite Schwingkreisspule 57 und einen zweiten Schwingkreiswiderstand 58 mit dem Drainanschluß des ersten Differenz-FETs 44 des zweiten Differenzverstärkers 46 verbunden. Die zusammengeschalteten Enden der Schwingkreisspulen 56, 57 sind über zwei in Durchlaßrichtung geschaltete Pegeldioden 59, 60 an die Schaltmassenleitung 36 gelegt. Die Schwingkreiswiderstände 55, 58 haben einen Wert von etwa 100 Ohm. Die Schwingkreisspulen 56, 57 weisen eine Induktivität von etwa 250 Pikohenry auf.

Der Drainanschluß des ersten Differenz-FETs 43 des ersten Differenzverstärkers 45 ist mit dem Drainanschluß des zweiten Differenz-FETs 48 des zweiten Differenzverstärkers 46 verbunden. Der Drainanschluß des ersten Differenz-FETs 44 des zweiten Differenzverstärkers 46 ist mit dem Drainanschluß des zweiten Differenz-FETs 47 des ersten Differenzverstärkers 45 verbunden.

Die zusammengelegten Drainanschlüsse der Differenz-FETen 43, 48 sind an dem Gateanschluß eines ersten Ausgangs-FETs 61 angeschlossen. Die zusammengeschalteten Drainanschlüsse der Differenz-FETen 44, 47 sind mit dem Gateanschluß eines zweiten Ausgangs-FETs 62 verbunden. Die Gateweiten der Ausgangs-FETen 61, 62 betragen 50 Mikrometer und die Gatelängen 0,3 Mikrometer. Die Drainanschlüsse der Ausgangs-FETen 61, 62 sind über einen Lastwiderstand 63 von etwa 100 Ohm an die Versorgungsspannungsleitung 36 gelegt und über eine an einen Abstimmspannungsanschluß 64 mit einer Abstimmspannung zum Einstellen der Mittenfrequenz des Resonanzkreises auf die Taktfrequenz des Datensignales beaufschlagbar.

Die Sourceanschlüsse der Ausgangs-FETen 61, 62 sind jeweils über Konstantstromquellen 65 mit jeweils einem selbstleitenden FET 66 und einem Gegenkopplungswiderstand 67 in der Schaltweise wie bei den Konstantstromquellen 37, 52 an die Versorgungsspannungsleitung 38 gelegt. Die Gegenkopplungswiderstände 67 der Konstantstromquellen 65 haben einen Wert von etwa 67 Ohm. Die selbstleitenden FETen 66 haben eine Gateweite von 15 Mikrometer und eine Gatelänge von 0,3 Mikrometer. Die Sourceanschlüsse der Ausgangs-FETen 61, 62 sind mit den Ausgangsanschlüssen 7, 8 verbunden.

Der oben beschriebene Flankendetektor 2 ist eine modifizierte Exklusiv-Oder-Schaltung, mit der bei einem Pegel-Null-Eins-Übergang durch Aktivierung des Differenz-FETs 43 und des Steuer-FETs 49 und bei einem Pegel-Eins-Null-Übergang durch Aktivieren des Differenz-FETs 48 und des Steuer-FETs 50 den auf die Taktfrequenz des an den Eingangsanschlüssen 5, 6 anliegenden Datensignales abgestimmten, durch die Schwingkreisspulen 56, 57 und die Kapazitäten der FETen 43, 44, 47, 48, 61, 62 gebildeten Schwingkreis zu einer Schwingung anregbar ist. An den Ausgangsanschlüssen 7, 8 liegt demzufolge ein Signal mit einer der Taktfrequenz des an den Eingangsanschlüssen 5, 6 anliegenden Datensignales entsprechenden Frequenz an. Durch das Vorsehen von zwei Differenzverstärkern 45, 46 weist das Ausgangssignal des Flankendetektors 2 eine doppelt balancierte Charakteristik auf. Durch die Kopplung der von den Steuer-FETen 49, 50 angesteuerten Differenzverstärker 45, 46 über den Koppelkondensator 51 ist ein Gleichstromanteil in dem Datensignal abtrennbar.

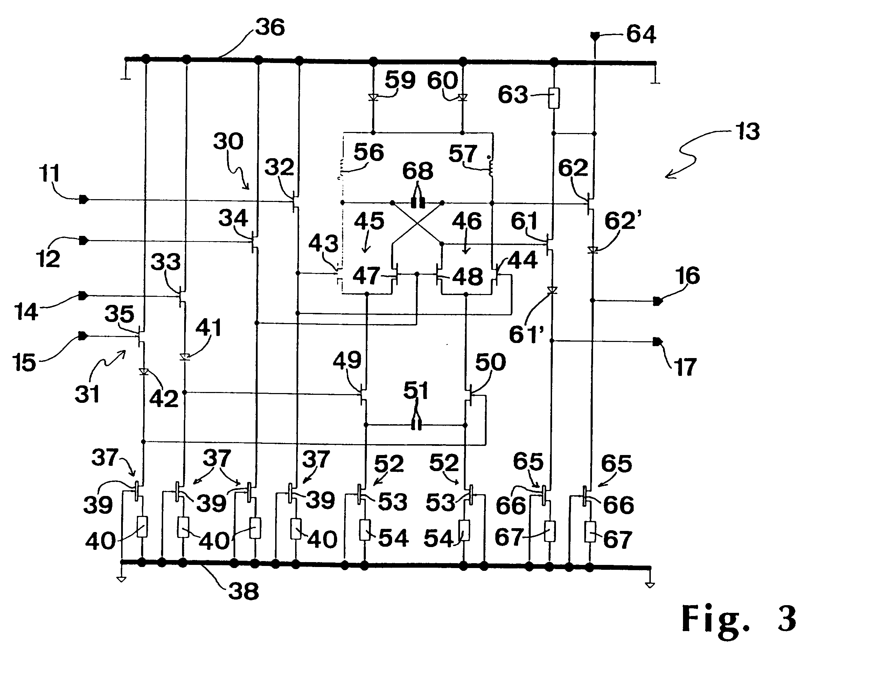

Fig. 3 zeigt das Schaltbild eines Ausführungsbeispieles des monolithisch integriert aufgebauten Frequenzmischers 13. An den ersten Eingangsanschlüssen 11, 12 liegt das Ausgangssignal des Flankendetektors 2 an. An den zweiten Eingangsanschlüssen 14, 15 liegt das Ausgangssignal des letzten Resonanzverstärkers 22 der Filter- und Verstärkereinheit 29 an. Der Aufbau des Frequenzmischers 13 entspricht weitgehend dem des Flankendetektors 2, wobei in Fig. 3 für Bauelemente des Frequenzmischers 13, die den Bauelementen des Flankendetektors 2 entsprechen, die gleichen Bezugszeichen vergeben sind.

Der Eingangsanschluß 11 ist mit dem Gateanschluß des ersten Eingangs-FETs 32 der ersten Eingangsstufe 30 verbunden. Der Eingangsanschluß 12 ist mit dem Gateanschluß des zweiten Eingangs-FETs 34 der ersten Eingangsstufe 30 verbunden. Der Eingangsanschluß 14 ist mit dem Gateanschluß des ersten Eingangs-FETs 33 der zweiten Eingangsstufe 31 und der Eingangsanschluß 15 mit dem Gateanschluß des zweiten Eingangs-FETs 35 der zweiten Eingangsstufe 31 verbunden. Die Drainanschlüsse der zweiten Differenz-FETen 47, 48 der Differenzverstärker 45, 46 sind mit einem Schwingkreiskondensator 68 von etwa 20 Femtofarad gebrückt. Die Schwingkreisspulen 57, 58 des Frequenzmischers 13 weisen eine Induktivität von etwa 550 Pikohenry auf.

In diesem Ausführungsbeispiel liegt die Taktfrequenz des Datensignales bei einem Wert, der zum Abstimmen des Resonanzkreises des Frequenzmischers 13 einen Schwingkreiskondensator 68 erfordert, der jedoch an der entsprechenden Position in dem Flankendetektor 2 durch dessen doppelt so hohe Arbeitsfrequenz nicht erforderlich ist. Bei einer gegenüber dieser Taktfrequenz deutlich erhöhten Taktfrequenz ist der Schwingkreiskondensator 68 in dem Frequenzmischer 13 nicht notwendig, während er bei einer deutlich erniedrigten Taktfrequenz in dem Flankendetektor 2 ebenfalls zwischen den zusammengeschalteten Drainanschlüssen der Differenz-FETen 43, 48 und der Differenz-FETen 44, 47 vorgesehen ist.

In dem Frequenzmischer 13 sind die Differenzverstärker 45, 46 und die daran angeschlossenen Steuer-FETen 49, 50 unabhängig voneinander über die ersten Eingangsanschlüsse 11, 12 und die zweiten Eingangsanschlüsse 14, 15 ansteuerbar. In einer Betriebsweise der Vorrichtung 1 zur Taktrückgewinnung weist das an den ersten Eingangsanschlüssen 11, 12 anliegende Signal die doppelte Frequenz wie das an den zweiten Eingangsanschlüssen 14, 15 anliegende Taktsignal auf, wobei der durch die Schwingkreisspulen 56, 57 und die Kapazitäten der FETen 43, 44, 47, 48, 61, 62 gebildete Schwingkreis auf die an den zweiten Eingangsanschlüssen 14, 15 eingespeiste Frequenz abgestimmt ist. Dadurch hat das Ausgangssignal des Frequenzmischers 13 an den Ausgangsanschlüssen 16, 17 die Frequenz des an den zweiten Eingangsanschlüssen 14, 15 anliegenden Signales.

Der Frequenzmischer 13 weist zur Pegelverschiebung und Unterdrückung von Rückkopplungen aus den nachgeschalteten Resonanzverstärkern 22 ausgangseitig Schutzdioden 61', 62' auf, die in Durchlaßrichtung zwischen die Sourceanschlüsse der Ausgangs-FETen 61, 62 und den Abgriffen der Ausgangsanschlüsse 16, 17 geschaltet sind.

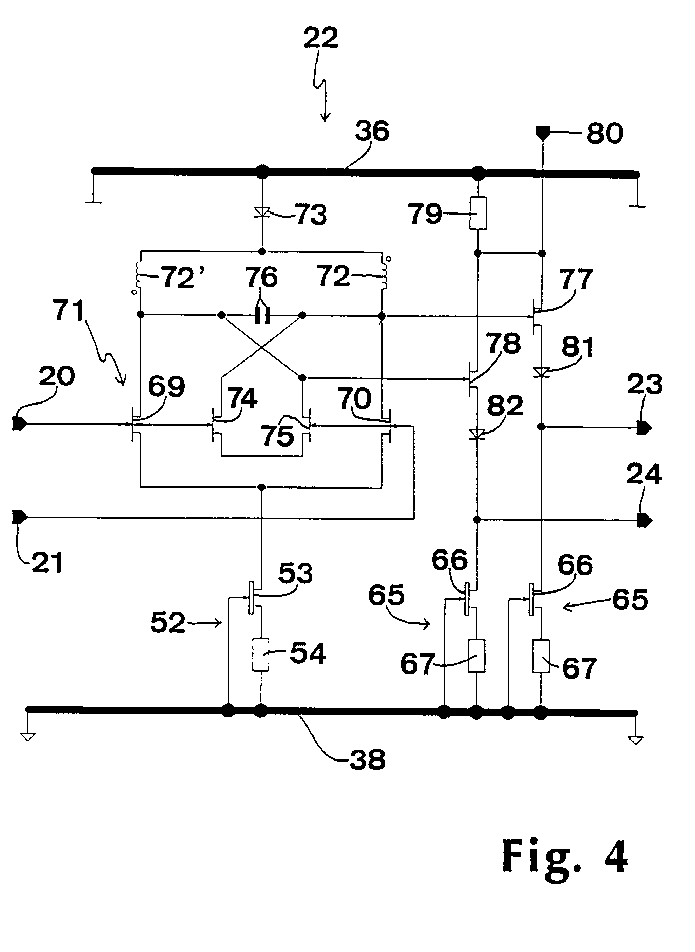

Das Ausgangssignal des Frequenzmischers 13 ist dem in dem Schaltbild der Fig. 4 dargestellten monolithisch integriert ausgeführten Resonanzverstärker 22 über die Eingangsanschlüsse 20, 21 einspeisbar. Mit dem Eingangsanschluß 20 sind der Gateanschluß eines ersten Differenz-FETs 69 und mit dem Eingangsanschluß 21 der Gateanschluß eines zweiten Differenz-FETs 70 eines Differenzverstärkers 71 verbunden, wobei die Differenz-FETen 69, 70 jeweils mit einer Gateweite von 10 Mikrometer und einer Gatelänge von 0,3 Mikrometer gefertigt sind.

Die Sourceanschlüsse der Differenz-FETen 69, 70 sind zusammengeschaltet und über eine Konstantstromquelle 52 an die Versorgungsspannungsleitung 38 angeschlossen. Die Drainanschlüsse der Differenz-FETen 69, 70 sind jeweils an die Enden von zwei Schwingkreisspulen 72', 72 angeschlossen. Die anderen Enden der Schwingkreisspulen 72', 72 sind zusammengeschaltet und über eine in Durch-laßrichtung geschaltete Pegeldiode 73 an die Schaltmassenleitung 36 gelegt.

Der Resonanzverstärker 22 weist zur gegenphasigen Koppelung parasitärer Kapazitäten des Differenzverstärkers 71 zwei Kompensations-FETen 74, 75 mit Gateweiten von 10 Mikrometer und Gatelängen von 0,3 Mikrometer auf, deren Sourceanschlüsse miteinander verbunden sind und deren Gateanschlüsse an jeweils einen Eingangsanschluß 20, 21 angeschlossen sind, wobei der Drainanschluß des mit dem Eingangsanschluß 20 verbundenen Kompensations-FETs 74 mit dem Drainanschluß des zweiten Differenz-FETs 70 und der Drainanschluß des mit dem Eingangsanschluß 21 verbundenen Kompensations-FETs 75 mit dem Drainanschluß des ersten Differenz-FETs 69 verbunden sind. Die Drainanschlüsse der FETen 69, 75 sind über einen Schwingkreiskondensator 76 mit einer Kapazität von etwa 20 Femtofarad mit den zusammengeschalteten Drainanschlüssen der FETen 70, 74 gebrückt.

Die miteinander verbundenen Drainanschlüsse des zweiten Differenz-FETs 70 sowie des Kompensations-FETs 74 und die zusammengeschalteten Drainanschlüsse des ersten Differenz-FETs 69 sowie des Kompensations-FETs 75 sind mit den Gateanschlüssen von zwei Ausgangs-FETen 77, 78 mit Gateweiten von 50 Mikrometer und Gatelängen von 0,3 Mikrometer verbunden, wobei die Drainanschlüsse der Ausgangs-FETen 77, 78 einerseits über einen Lastwiderstand 79 von etwa 100 Ohm mit der Schaltmassenleitung 36 verbunden sind, und andererseits über einen Abstimmspannungsanschluß 80 mit einer Abstimmspannung beaufschlagbar sind. Mit der Abstimmspannung ist die Resonanzfrequenz des durch die Schwingkreisspulen 72', 72 sowie den daran angeschlossenen Kapazitäten gebildeten Schwingkreis abstimmbar.

Die Sourceanschlüsse der Ausgangs-FETen 77, 78 sind über in Durchlaßrichtung geschaltete Schutzdioden 81, 82 zur Pegelverschiebung und Unterdrückung von Rückkopplungen aus nachgeschalteten Resonanzverstärkern 22 sowie Konstantstromquellen 65 an die Versorgungsspannungsleitung 38 angeschlossen. Die Ausgangsanschlüsse 23, 24 sind drainseitig mit den Konstantstromquellen 65 verbunden.

Die Phasenanpassung zwischen den an den ersten Eingangsanschlüssen 11, 12 und den zweiten Eingangsanschlüssen 14, 15 anliegenden Signalen auf einen Phasenwinkel von vorteilerhafterweise etwa 90 Grad oder 270 Grad erfolgt über Phasenverschiebung durch den Frequenzmischer 13, die Resonanzverstärker 22 sowie die Länge der Rückkoppelleitungen 27, 28, wobei die Feinabstimmung über die Einstellung der an den Abstimmspannungsanschlüssen 64, 80 anliegenden Abstimmspannung erfolgt.

Der Resonanzverstärker 22 weist eine Güte von etwa 20 auf. Wie in Fig. 1 dargestellt, bilden die in Reihe geschalteten Resonanzverstärker 22 eine Filter- und Verstärkereinheit 29, deren Gesamtgüte mit der Anzahl und Güte der einzelnen Resonanzverstärker 22 im wesentlichen proportional zunimmt. Durch den schaltungstechnisch verhältnismäßig einfachen Aufbau und der damit verbundenen technologischen unproblematischen monolithischen Integrierbarkeit des Resonanzverstärkers 22 ist somit bei einer verhältnismäßig geringen Anzahl eine zur Taktrückgewinnung ausreichend hohe Güte von etwa 500 erreichbar.

Wie den Schaltbildern gemäß der Fig. 2, Fig. 3 und Fig. 4 entnehmbar ist, weisen der Flankendetektor 2 und der Frequenzmischer 13 in diesen Ausführungsbeispielen eine sehr ähnliche Schaltungsstruktur auf. Auch die Baugruppen des Resonanzverstärkers 22 sind mit den entsprechenden Baugruppen des Frequenzmischers 13 bis auf geänderte Leitungsführung sehr ähnlich. Aus diesem Grunde sind die Herstellungsverfahren für den Flankendetektor 2, den Frequenzmischer 13 und die Resonanzverstärker 22 in einfacher Weise reproduzierbar, so daß die Herstellungskosten niedrig gehalten sind.

## Patentansprüche

1. Vorrichtung zur Taktrückgewinnung aus einem insbesondere aus einem digitalen Datensignal gebildeten wechselspannungsbehafteten Eingangssignal mit einem Frequenzmischer (13), dem an einem ersten Eingang (11, 12) ein der Taktfrequenz des wechselspannungsbehafteten Eingangssignales zugeordnetes Signal einspeisbar ist, mit einem Filter und einem Verstärkermit denen ein schmalbandiger Frequenzbereich des Ausgangssignales des Frequenzmischers (13) verstärkbar ist, wobei die aus dem Filter und dem Verstärker gebildete Filter- und Verstärkereinheit eine hohe Gesamtgüte aufweist. und mit einer Rückkoppelleitung (27, 28), mit der das Ausgangssignal des Verstärkers einem zweiten Eingang (14, 15) des Frequenzmischers (13) zuführbar ist, dadurch gekennzeichnet, daß wenigstens zwei in Reihe geschaltete, die Filter- und Verstärkereinheit (29) bildende Resonanzverstärker (22) vorgesehen sind, die Schwingkreise mit in monolithisch integrierter Bauweise ausgeführten Induktivitäten (72, 72') aufweisen, wobei die Resonanzverstärker (22) eine im Vergleich zu der Gesamtgüte der Filter- und Verstärkereinheit (29) niedrige Güte aufweisen, so daß mit der aus den kaskadierten Resonanzverstärkern (22) gebildeten Filter- und Verstärkereinheit (29) hoher Gesamtgüte ein schmalbandiger Frequenzbereich des Ausgangssignales des Frequenzmischers (13) verstärkbar ist.

2. Vorrichtung nach Anspruch 1, dadurch gekennzeichnet, daß jeder Resonanzverstärker (22) eine ausgangsseitige Schutzschaltung (77, 78, 81, 82) zur Lasttrennung aufweist.

3. Vorrichtung nach Anspruch 1 oder Anspruch 2, dadurch gekennzeichnet, daß jeweils ein Resonanzverstärker (22) jeweils einen Differenzverstärker (71) mit zwei Feldeffekttransistoren (69, 70) aufweist, deren Drainanschlüsse jeweils über eine als Spule (72, 72') ausgeführte Induktivität und wenigstens eine Diode (73) an eine Schaltmasse (36) angeschlossen sind, deren Gateanschlüsse an Eingangsanschlüsse (20, 21) des Resonanzverstärkers (22) angeschlossen sind und deren Sourceanschlüsse über eine Konstantstromquelle (52) an einer negativen Versorgungsspannung (38) liegen.

4. Vorrichtung nach Anspruch 3, dadurch gekennzeichnet, daß die Feldeffekttransistoren (69, 70) mit einer aus zwei Ausgangsfeldeffekttransistoren (77, 78) und zwei Dioden (81, 82) gebildeten Schutzschaltung verbunden sind, wobei die Drainanschlüsse der Feldeffekttransistoren (69, 70) jeweils mit dem Gateanschluß eines Ausgangsfeldeffekttransistors (77, 78) verbunden sind, die Drainanschlüsse der Ausgangsfeldeffekttransistoren (77, 78) mit einer Abstimmspannung beaufschlagbar sind und die Sourceanschlüsse über die in Durchlaßrichtung geschalteten Dioden (81, 82) sowie Konstantstromquellen (65) an die Versorgungsspannung (38) gelegt sind.

5. Vorrichtung nach Anspruch 4, dadurch gekennzeichnet, daß die Feldeffekttransistoren (69, 70) mit zwei Kompensationsfeldeffekttransistoren (74, 75) gekoppelt sind, wobei der erste Kompensationsfeldeffekttransistor (74) mit seinem Drainanschluß an dem Drainanschluß des ersten Feldeffekttransistors (70) sowie mit seinem Gateanschluß an dem Gateanschluß des zweiten Feldeffekttransistors (69) und der zweite Kompensationsfeldeffekttransistor (75) mit seinem Drainanschluß an dem Drainanschluß des zweiten Feldeffekttransistors (69) sowie mit seinem Gateanschluß an dem Gateanschluß des ersten Feldeffekttransistors (70) angeschlossen sind.

6. Vorrichtung nach Anspruch 5, dadurch gekennzeichnet, daß zwischen den zusammengeschalteten Drainanschlüssen des ersten Feldeffekttransistors (70) sowie des ersten Kompensationsfeldeffekttransistors (74) und den zusammengeschalteten Drainanschlüssen des zweiten Feldeffekttransistors (69) sowie des zweiten Kompensationsfeldeffekttransistors (75) ein Kondensator (76) vorgesehen ist.

7. Vorrichtung nach einem der Ansprüche 1 bis 6, dadurch gekennzeichnet, daß die Resonanzverstärker (22) so ausgelegt sind, daß das Ausgangssignal des in Signallaufrichtung letzten Resonanzverstärkers (22) gegenüber dem an dem ersten Eingang (11, 12) des Frequenzmischers (13) anliegenden Signal um wenigstens ein Viertel der Taktperiode des wechselspannungsbehafteten Eingangssignales verzögert ist.

8. Vorrichtung nach Anspruch 7, dadurch gekennzeichnet, daß zur Verzögerung des Ausgangssignales des letzten Resonanzverstärkers (22) ein Paar von Verzögerungsleitungen (27, 28) vorgesehen ist.

## Claims

1. Device for clock recovery from an input signal affected by alternating current and formed from a digital data signal, having a frequency mixer (13) into which a signal associated with the clock frequency of the input signal affected by alternating current may be fed, at a first input (11, 12), having a filter and an amplifier with which a narrow-band frequency range of the output signal of the frequency mixer (13) may be amplified, the filter and amplifier unit formed from the filter and the amplifier being of very high overall quality, and having a feedback line (27, 28) through which the output signal of the amplifier may be led to a second input (14, 15) of the frequency mixer (13), **characterised in that** at least two resonance amplifiers (22), connected in series and forming the filter and amplifier unit (29), are provided, which have resonant circuits with inductive resistors (72,72') which are of monolithic integrated construction, the resonance amplifiers (22) being of low quality in comparison with the overall quality of the filter and amplifier unit (29), such that a narrow-band frequency range of the output signal of the frequency mixer (13) may be amplified with the filter and amplifier unit (29) formed from the cascaded resonance amplifiers (22).

2. Device according to claim 1, **characterised in that** each resonance amplifier (22) has a protective circuit (77,78,81,82) on the output side to break the load.

3. Device according to claim 1 or claim 2, **characterised in that** in each case one resonance amplifier (22) has respectively one differential amplifier (71) with two field effect transistors (69, 70), the drain terminals of which are respectively connected to a switching mass (36) via an inductive resistor realised as a coil (72, 72') and at least one diode (73), the gate terminals of which transistors are connected to input terminals (20, 21) of the resonance amplifier (22), and the source terminals of which are connected to a negative distribution voltage (38) via a constant-current source (52).

4. Device according to claim 3, **characterised in that** the field effect transistors (69, 70) are connected to a protective circuit formed from two output field effect transistors (77, 78) and two diodes (81, 82), the drain terminals of the field effect transistors (69, 70) being respectively connected with the gate terminal of an output field effect transistor (77, 78), the drain terminals of the output field effect transistors (77, 78) being able to be charged with a tuning voltage, and the source terminals being connected to the distribution voltage (38) via diodes (81,82), connected in the conducting direction, and constant-current sources (65).

5. Device according to claim 4, **characterised in that** the field effect transistors (69, 70) are coupled with two compensating field effect transistors (74, 75), the first compensating field effect transistor (74) being connected with its drain terminal to the drain terminal of the first field effect transistor (70) and with its gate terminal to the gate terminal of the second field effect transistor (69), and the second compensating field effect transistor (75) being connected with its drain terminal to the drain terminal of the second field effect transistor (69) and with its gate terminal to the gate terminal of the first field effect transistor (70).

6. Device according to claim 5, **characterised in that** a capacitor (76) is provided between the interconnected drain terminals of the first field effect transistor (70) and of the first compensating field effect transistor (74) and the interconnected drain terminals of the second field effect transistor (69) and of the second compensating field effect transistor (75).

7. Device according to one of claims 1 to 6, **characterised in that** the resonance amplifiers (22) are laid out in such a way that the output signal of the last resonance amplifier (22) in the signal flow direction is delayed in relation to the signal adjacent to the first input (11, 12) of the frequency mixer (13) by at least a quarter of the clock period of the input signal which is affected by alternating current.

8. Device according to claim 7, **characterised in that** a pair of delay lines (27, 28) is provided to delay the output signal of the last resonance amplifier (22).

## Revendications

1. Dispositif de récupération de signal d'horloge à partir d'un signal d'entrée, affecté par une tension alternative, formé en particulier à partir d'un signal de données numérique, avec un mélangeur de fréquence (13), auquel on peut fournir sur une première entrée (11, 12) un signal associé à la fréquence d'horloge du signal d'entrée affecté par une tension alternative, avec un filtre et un amplificateur, avec lesquels on peut amplifier une plage de fréquence à bande étroite du signal de sortie du mélangeur de fréquence (13), l'unité de filtrage et d'amplification, qui est constituée par le filtre et par l'amplificateur présentant un facteur de qualité global élevé, et avec une ligne de rétroaction (27, 28), avec laquelle le signal de sortie de l'amplificateur peut être amené à une deuxième entrée (14, 15) du mélangeur de fréquence (13),
caractérisé en ce que
l'on prévoit au moins deux amplificateurs à circuits accordés (29) formant l'unité de filtrage et d'amplification (29), montés en série, qui présentent des circuits oscillants avec des inductances (72, 72') réalisées selon un mode de construction intégré, monolithique, les amplificateurs à circuits accordés (22) présentant un facteur de qualité bas par comparaison avec le facteur de qualité global de l'unité de filtrage et d'amplification (29), de telle sorte que l'on peut amplifier une plage de fréquence à bande étroite du signal de sortie du mélangeur de fréquence (13) avec l'unité de filtrage et d'amplification (29) formée d'amplificateurs à circuits accordés (22) montés en cascade.

2. Dispositif selon la revendication 1,
caractérisé en ce que
chaque amplificateur à circuit accordé (22) présente un circuit de protection du côté sortie (77, 78, 81, 82) pour la coupure en charge.

3. Dispositif selon la revendication 1 ou la revendication 2,
caractérisé en ce qu'
il présente respectivement un amplificateur à circuit accordé (22) et respectivement un amplificateur différentiel (71) avec deux transistors à effet de champ (69, 70), dont les bornes de drain sont respectivement raccordées à une masse (36) au moyen d'une inductance, réalisée sous la forme d'une bobine (72, 72') et d'au moins une diode (73), dont les bornes de grille sont raccordées aux bornes d'entrée (20, 21) de l'amplificateur à circuit accordé (22) et dont les bornes de source se trouvent à une tension d'alimentation négative (38) au moyen d'une source d'alimentation en courant constant (52).

4. Dispositif selon la revendication 3,
caractérisé en ce que
les transistors à effet de champ (69, 70) sont reliés à un circuit de protection formé à partir de deux transistors à effet de champ de sortie (77, 78) et de deux diodes (81, 82), les bornes de drain des transistors à effet de champ (69, 70) étant respectivement reliées à la borne de grille d'un transistor à effet de champ de sortie(77, 78), les bornes de drain des transistors à effet de champ de sortie (77, 78) pouvant être alimentés par une tension d'accord, et les bornes de source étant mises au moyen des diodes (81, 82) montées dans le sens du passage ainsi qu'au moyen des sources d'alimentation en courant constant (65) à la tension d'alimentation (38).

5. Dispositif selon la revendication 4,
caractérisé en ce que
les transistors à effet de champ (69, 70) sont couplés avec deux transistors à effet de champ de compensation (74, 75), (74) le premier transistor à effet de champ de compensation étant raccordé par sa borne de drain à la borne de drain du premier transistor à effet de champ (70) ainsi que par sa borne de grille à la borne de grille du deuxième transistor à effet de champ (69) et le deuxième transistor à effet de champ de compensation (75) étant raccordé par sa borne de drain à la borne de drain du deuxième transistor à effet de champ (69) ainsi que par sa borne de grille à la borne de grille du premier transistor à effet de champ (70).

6. Dispositif selon la revendication 5,
caractérisé en ce que
l'on prévoit un condensateur (76) entre les bornes de drain du premier transistor à effet de champ (70), ainsi que du premier transistor à effet de champ de compensation (74), montées ensemble, et les bornes de drain du deuxième transistor à effet de champ (69), ainsi que du deuxième transistor à effet de champ de compensation (75), montées ensemble.

7. Dispositif selon l'une des revendications 1 à 6,
caractérisé en ce que
les amplificateurs à circuits accordés (22) sont conçus de telle sorte que le signal de sortie du dernier amplificateur à circuit accordé (22), dans le sens de passage des signaux, est retardé par rapport au signal qui se trouve sur la première entrée (11, 12) du mélangeur de fréquence (13), d'au moins un quart de la période d'horloge du signal d'entrée affecté par une tension alternative.

8. Dispositif selon la revendication 7,
caractérisé en ce que
pour retarder le signal de sortie du dernier amplificateur à circuit accordé (22) on prévoit une paire de lignes de retard (27, 28).
